# EUROPÄISCHE PATENTSCHRIFT

(11) **EP 0 941 644 B1**
(45) Veröffentlichungstag und Bekanntmachung des Hinweises auf die Patenterteilung: **24.01.2007**
(21) Anmeldenummer: 97951985.7
(22) Anmeldetag: 27.11.1997
(51) Int. Cl.: H05K 9/00

(54) **ELEKTRONISCHER SCHALTKREIS MIT EINEM HOCKFREQUENZBEDÄMPFENDEN SCHIRMGEHÄUSE**
ELECTRONIC CIRCUIT WITH A SCREENING CASE TO ATTENUATE HIGH-FREQUENCY INTERFERENCE
CIRCUIT ELECTRONIQUE A BOITIER DE BLINDAGE ATTENUANT LA HAUTE FREQUENCE

(30) Priorität: 02.12.1996 DE 19649848
(43) Veröffentlichungstag der Anmeldung: 15.09.1999
(73) Patentinhaber: SIEMENS AKTIENGESELLSCHAFT, 80333 München (DE)
(72) Erfinder: BARZ, Herbert, D-65439 Flörsheim (DE)
(86) Internationale Anmeldenummer: PCT/EP1997/006607
(87) Internationale Veröffentlichungsnummer: WO 1998/025443

(56) Entgegenhaltungen:
- EP-A- 0 380 740
- DE-A- 4 317 469
- US-A- 5 014 160

## Beschreibung

Die Erfindung bezieht sich auf einen elektronischen Schaltkreis, bestehend aus elektrischen und elektronischen Bauelementen und deren Verbindungsleitungen auf einer Leiterplatte, wobei ein Schirmgehäuse den elektronischen Schaltkreis zur Verhinderung von Störungen, die auf den elektronischen Schaltkreis einwirken und die durch den elektronischen Schaltkreis hervorgerufen werden, hochfrequenzbedämpfend umschließt, wobei der Schaltkreis aus dem Schirmgehäuse nach außen führende Anschlussleitungen aufweist. Dieser Schaltkreis ist vorgesehen insbesondere zum Einbau in eine Grundplatte in einem Kfz-Kombinationsinstrument, bei dem verschiedene Anzeigeinstrumente, Anzeigefelder, Kontroll- und Warnleuchten sowie die dazu erforderlichen elektrischen und elektronischen Ausrüstungsteile in einem gemeinsamen Gehäuse angeordnet und durch eine gemeinsame Sichtscheibe abgedeckt sind.

Aus der DE 43 17 469 A1 und der US 5,014,160 B ist es bekannt, auf einer Leiterplatte abzuschirmende Bauteile mit einem Schirmgehäuse zu umgeben und über Anschlussleitungen mit außerhalb des Schirmgehäuses angeordneten Bauteilen zu verbinden.

Aus der EP 0 380 740 A2 ist eine Abschirmbox bekannt, bei der der Schaltkreis vollständig von einem Abschirmgehäuse umgeben ist und Kontaktmittel in Form von Kontaktfedern den Schaltkreis mit einer Grundplatte verbinden, die alle für die Funktion des Kombinationsinstruments erforderlichen sonstigen aktiven und passiven Schaltelemente, Leiterbahnen, Steckverbinder und Anschlusspunkte enthält. Hierbei ist der Schaltkreis auf einer Leiterplatte untergebracht und über verschiedenförmige Kontaktfedern, die durch das Abschirmgehäuse geführt sind, mit der Grundplatte verbunden. Nachteilig bei dieser Abschirmung ist es, dass verschiedenförmige Kontaktmittel benötigt werden. Weiterhin lässt sich das bekannte Abschirmgehäuse nur aufwendig von Hand montieren.

Aufgabe der Erfindung ist daher, einen elektronischen Schaltkreis der eingangs genannten Art zu schaffen, der bei einfachem Aufbau und leicht montierbarer Weise gut abgeschirmt ist.

Diese Aufgabe wird durch einen Schaltkreis mit den Merkmalen des Anspruchs 1 gelöst. Bei dieser Lösung ist es vorteilhaft, daß auf einen Halterahmen zur Führung der Kontaktmittel und zur Verhinderung eines Kontakts zwischen den Kontaktmitteln und dem Schirmgehäuse verzichtet werden kann. Weiterhin ist es durch diese Bauweise möglich, ein Rastermaß der einzelnen Kontaktmittel mit dem üblichen Wert von 1/10 Inch (entsprechend 2,54 mm) in einer Reihe zu realisieren.

Vorteilhafte Ausgestaltungen der Erfindungen sind den Unteransprüchen zu entnehmen. Besonders vorteilhaft ist es, die Abschirmmittel derart auszugestalten, daß auf der Leiterplatte Kontaktmittel vorgesehen sind, die elektrisch leitend mit dem Schirmgehäuse verbunden sind, und über Kondensatoren innerhalb des Gehäuses die Kontaktmittel mit den Anschlußleitungen zu verbinden. Hierbei ist es vorteilhaft, daß der Anschluß der Filterbauteile, insbesondere Kondensatoren möglichst nahe der Gehäusewand erfolgen kann, um die wirksame Länge der ungeschützten Anschlußleitungen möglichst kurz zu halten. Weiterhin ist hierbei vorteilhaft, daß die Filterkondensatoren ein preiswertes und wirksames Schirmmittel darstellen.

Durch Verwendung der Druckkontakte kann vorteilhafter Weise auf eine starre Verbindung verzichtet werden. Gleichzeitig wird dadurch ein Lösen der Verbindung wegen der unterschiedlichen Wärmeausdehnungen der Leiterplatte und des Schirmgehäuses verhindert. Weiterhin wird durch die unterschiedlichen Ausdehnungen der Leiterplatte und des Schirmgehäuses eine Reibung der sich kontaktierenden Bauteile erreicht, die eventuell vorhandene Verunreinigungen beseitigt. Der Druckkontakt ist beispielsweise kronenförmig ausgeführt.

Die Ausbildung der Kontaktmittel als Löthöcker ist einfach aufzubauen und gleichzeitig sehr wirksam. Weiterhin ist daran vorteilhaft, daß die Löthöcker gleichzeitig mit den Anschlüssen für die SMDs hergestellt werden können.

Durch eine elektrisch gut leitende Verbindung der einzelnen Kontaktmittel mit einer Masseringleitung werden mögliche Potentialunterschiede- ausgeglichen und die Hochfrequenzdichtheit des Schirmgehäuses insgesamt erhöht.

Die Durchkontaktierungen der Ringleitungen dienen gleichzeitig als Schirmgitter. Für abzuschirmende Frequenzen bis 1 GHz erweist sich ein Abstand der einzelnen Kontaktierungen von etwa 12 mm als vorteilhaft.

Durch das Drücken der Seitenteile des Schirmgehäuses auf die Kontaktmittel wird eine preisgünstige und wirksame Druckkontaktverbindung zwischen dem Schirmgehäuse und den Filterbauteilen realisiert.

Durch die Verwendung von verzinntem ferromagnetischem Blech für das Schirmgehäuse und Löthöckern aus Zinn wird eine Kontaktoxydation der Leiterbahnen vermieden und so eine gute elektrische Verbindung sichergestellt.

Dadurch, daß die Leiterplatte Schlitze aufweist, durch die Laschen des Schirmgehäuses geführt sind, ist eine einfach aufgebaute elektrische und mechanische Verbindung zwischen der Schirmgehäusedose und dem Schirmgehäusedeckel durch ein Umbiegen der Laschen, um z.B. den Schirmgehäusedeckel möglich. Außerdem wird durch das Umbiegen der Laschen gleichzeitig das Schirmgehäuse auf der Leiterplatte derart fixiert, daß das Gehäuse auf die Kontaktmittel dauerhaft gepreßt wird. Die Laschen dienen weiterhin als Durchkontaktierungen zum Deckel.

Durch Verwendung von Aluminiumoxid-Keramik für die Leiterplatte wird eine gute Wärmeableitung für die Bauteile sichergestellt.

Durch die Multilayertechnik werden komplexe Schaltkreise auf kleinstem Raum ermöglicht.

Schließlich wird durch ein Abstimmen der Kondensatoren auf die Störfrequenz mit der höchsten Amplitude der jeweiligen Leitungen erreicht, daß die Störungen bestmöglich unterdrückt werden.

Bei einer Verwendung von Kontaktfedern als Anschlußmittel können die unterschiedlichen Wärmeausdehnungen zwischen der Leiterplatte und der Grundplatte ohne mechanische Spannungen ausgeglichen werden.

Nachfolgend wird die Erfindung anhand der Zeichnungen für ein besonders bevorzugtes Ausführungsbeispiel erläutert:

Es zeigen:
- Figur 1: die Aufsicht auf eine besonders bevorzugte erfindungsgemäße Leiterplatte,
- Figur 2: die Stanzformen eines besonders bevorzugten erfindungsgemäßen Schirmgehäuses,
- Figur 3: die Seitenansicht der Leiterplatte aus Figur 1 mit dem besonders bevorzugen erfindungsgemäßen montierten Schirmgehäuse aus Figur 2 auf einer Grundplatte befestigt,
- Figur 4: die Aufsicht auf die Leiterplatte aus Figur 1 mit dem besonders bevorzugten erfindungsgemäßen Schirmgehäuse aus Figur 2 in Aufsicht,
- Figur 5: den Schnitt D-E aus Figur 4,
- Figur 6: den Schnitt B-C aus Figur 4.

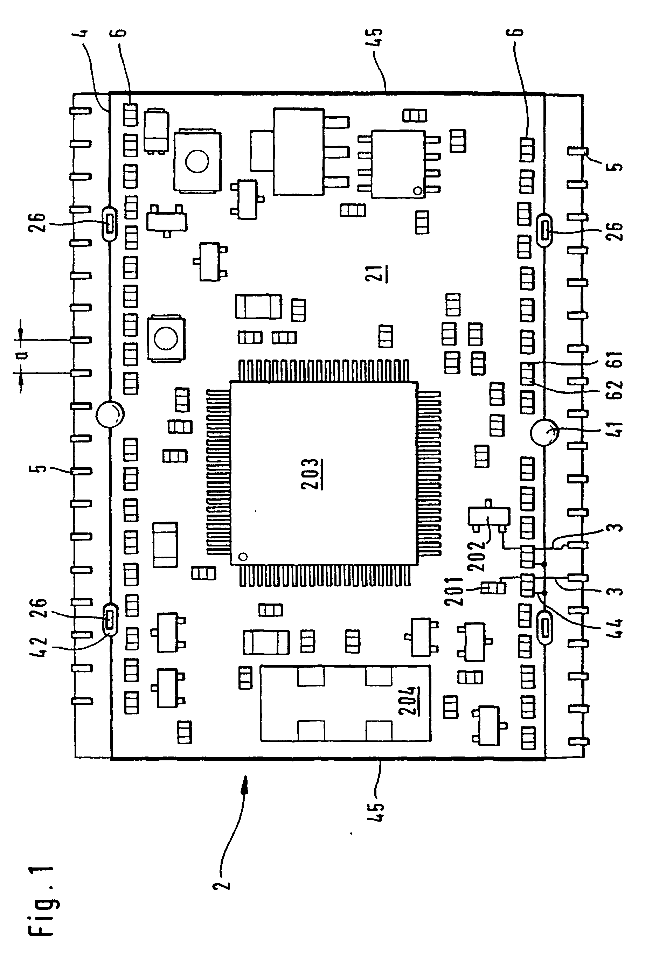

In Figur 1 besteht die Leiterplatte 2 aus Metallkeramik und weist Schlitze 26 auf. Auf der Oberseite 21 der Leiterplatte 2 ist eine Masseringleitung 4 mit Löthöckern 41, 42 vorhanden. Entlang der Längsseiten der Leiterplatte 2 sind Kondensatoren 6 mit jeweils einem Anschluß-Pin 62 über jeweils eine Massezuleitung 44 mit der Masseringleitung 4 verbunden. Anschlußleitungen 3 verbinden jeweils eine Kontaktfeder 5 über jeweils einen Anschluß-Pin 61 jeweils eines Kondensators 6 mit dem elektronischen Schaltkreis, bestehend aus dem Mikroprozessor 203, einem Schwingquarz 204, elektronischen Bauelementen 201, 202 und den weiteren sonstigen abgebildeten elektronischen Bauteilen, die zur Funktion des Mikroprozessors 203 erforderlich sind und der besseren Übersichtlichkeit nicht mit Bezugszeichen versehen sind. Der besseren Übersichtlichkeit wegen ist nur jeweils eine Verbindung der elektronischen Bauteile 201, 202 mit den jeweiligen Kontaktfedern 5 dargestellt. Auch die übrigen Kontaktfedern 5 sind über nicht dargestellte Anschlußleitungen 3 mit dem elektronischen Schaltkreis verbunden, wobei jeweils ein Kondensator 6 mit seinen Anschluß-Pins 61, 62 jeweils eine Anschlußleitung 3 hochfrequenzmäßig über eine Massezuleitung 44 mit der Masseringleitung 4 und den Löthökkern 41, 42 verbindet. Die Masseringleitung 4 ist im Bereich der Kreuzungen mit den Anschlußleitungen 3 gegen diese elektrisch isoliert. Der Schaltkreis ist in an sich bekannter Weise in Mehrlagentechnik (Multilayer) ausgeführt. Die Masseringleitung 4 ist vorteilhafter Weise im Bereich der Schmalseite der Leiterplatte 2 nicht nur auf der Oberseite 21 ausgebildet, sondern weist auch auf der Seitenfläche der Leiterplatte 2 einen Überstand 45 über dem Rand der Oberfläche 21 auf.

Durch den erfindungsgemäßen Aufbau ist es möglich, mit Kondensatoren 6 der Baugröße 0603 ein Rastermaß a = 2,54 mm zu realisieren.

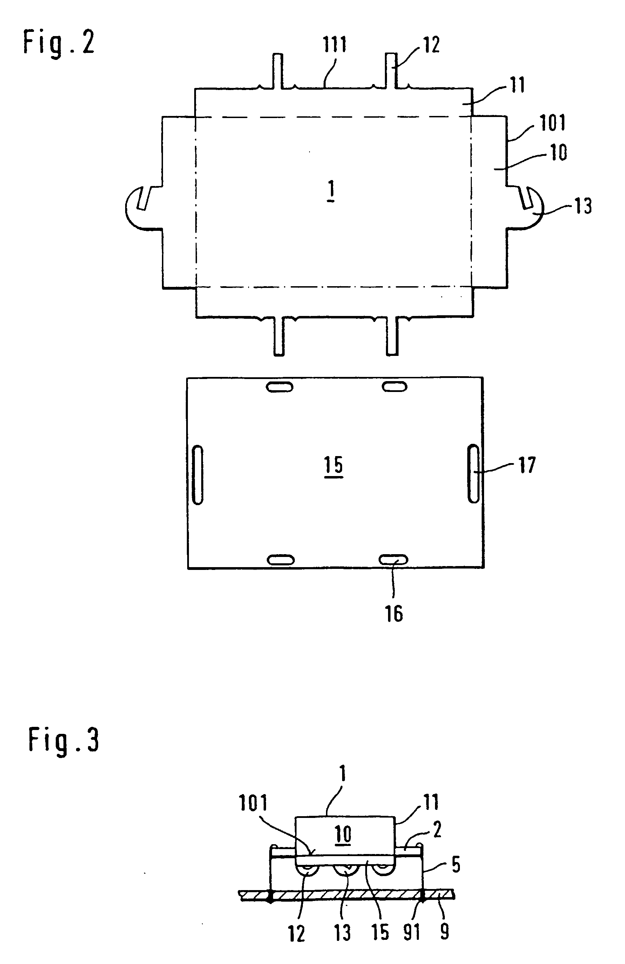

In Figur 2 sind die Stanzteile eines besonders bevorzugten Schirmgehäuses aus verzinntem Weißblech, bestehend aus einer Schirmgehäusedose 1 und einem Schirmgehäusedeckel 15 dargestellt. Die Schirmgehäusedose 1 weist Schmalseiten 10 und Längsseiten 11 auf. Die Längsseiten 11 sind an ihren Unterseiten 111 mit Biegelaschen 12 verlängert. Die Schmalseiten 10 sind an ihren Unterseiten 101 mit Verschränklaschen 13 verlängert. Der Schirmgehäusedeckel 15 weist Schlitze 16 zum Durchstecken der Biegelaschen 12 und Schlitze 17 zum Durchstecken der Verschränklaschen 13 auf. Vor der Montage werden die Längsseiten 11 und Schmalseiten 10 jeweils um 90 Grad gebogen, so daß sich eine Dose mit vier Seitenwänden und einem Boden ergibt.

Figur 3 zeigt die Ansicht des Schirmgehäuses aus Figur 2 auf die Leiterplatte aus Figur 1 montiert und auf einer Grundplatte 9 befestigt. Die Biegelaschen 12 der Längsseiten 11 sind durch die Schlitze 26 der Leiterplatte 2 und die Schlitze 16 des Schirmgehäusedeckels 15 gesteckt und so umgebogen, daß sie gegen den Schirmgehäusedeckel 15 drücken. Der Schirmgehäusedeckel 15 liegt weiterhin auf der Unterseite 101 der Schmalseite 10 auf. Gleichzeitig sind die Verschränklaschen 13 durch den Schlitz 17 des Schirmgehäusedeckels 15 gesteckt und verschränkt. So drücken auch sie besonders dauerhaft den Schirmgehäusedeckel 15 gegen die Unterseite 101 der Schmalseite 10.

Die Montage des Schirmgehäuses erfolgt vorteilhafterweise so: Die Schirmgehäusedose 1 liegt derart, daß sie nach obenhin geöffnet ist und die Biegelaschen 12 und Verschränklaschen 13 nach oben ragen. Dann wird die Leiterplatte 2 mit ihrer Oberseite 21 nach unten derart auf die Schirmgehäusedose aufgesetzt, daß die Biegelaschen 12 durch die Schlitze 26 ragen. Nachfolgend wird der Schirmgehäusedeckel 15 derart aufgesetzt, daß die Biegelaschen 12 durch die Schlitze 16 und die Verschränklaschen 13 durch die Schlitze 17 ragen. Schließlich werden die Biegelaschen 12 umgebogen und die Verschränklaschen 13 verschränkt.

Die Leiterplatte 2 ist mittels der Kontaktfedern 5 mit der Grundplatte 9 elektrisch und mechanisch verbunden, in vorliegendem Fall beispielsweise mittels Wellenlötungen 91.

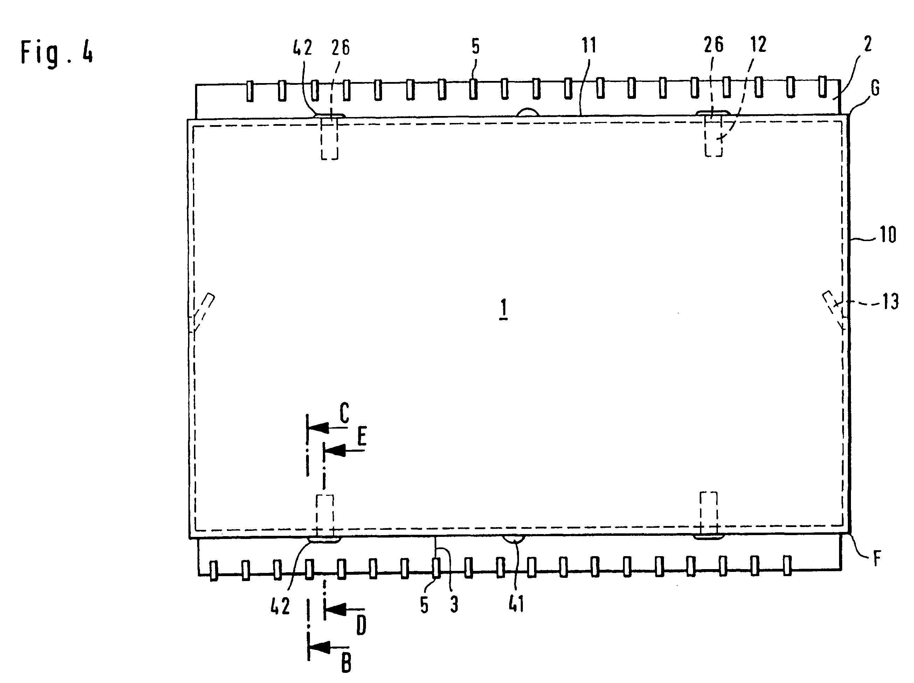

In Figur 4 ist die Schirmgehäusedose 1 auf die Oberseite 21 der Leiterplatte 2 aufgesetzt. Die Schirmgehäusedose 1 wird mit den Unterseiten111 ihrer Längsseiten 11 auf die Löthöcker 41, 42 gepreßt und ist so mit der Masseringleitung 4 elektrisch verbunden. Die Schmalseiten 10 der Schirmgehäusedose 1 bedecken im Bereich zwischen den Punkten F und G auch die Seitenfläche der Leiterplatte 2 und die Seite eines eventuell vorhandenen Multilayer-Bereichs auf der Unterseite 22 der Leiterplatte 2. So wird die Seitenfläche 10 der Schirmgehäusedose 1 mit ihrer Innenseite gegen den Überstand 45 gedrückt und so ebenfalls mit der Masseringleitung 4 elektrisch verbunden.

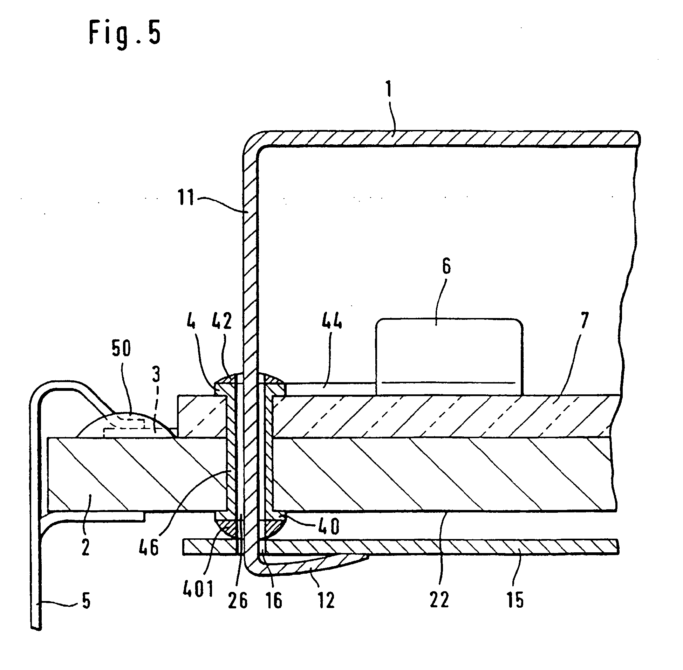

Figur 5 zeigt den Schnitt D-E aus Figur 3. Die Leiterplatte 2 weist auf ihrer Unterseite eine weitere Masseringleitung 40 auf. Die Biegelasche 12 der Schirmgehäusedose 1 ist durch den Schlitz 26 der Leiterplatte 2 und den Schlitz 16 des Schirmgehäusedeckels 15 gesteckt und so gegen den Schirmgehäusedeckel 15 gebogen, daß der Schirmgehäusedeckel 15 gegen den Löthöcker 401 gedrückt wird, der sich auf der Masseringleitung 40 befindet. Die Masseringleitungen 4, 40 sind durch eine Durchkontaktierung 46, die den Rand des Schlitzes 26 auskleidet, miteinander elektrisch leitend verbunden. Weitere nicht dargestellte Durchkontaktierungen sind z.B. unter den Löthöckern 41 (in Figur 1 dargestellt) vorhanden. Die Massezuleitung 44 verbindet den Kondensator 6 mit der Masseringleitung 4. Die Kontaktfeder 5 ist mittels des Lotes 50 elektrisch und mechanisch mit der Anschlußleitung 3 verbunden. Im vorliegenden Schnitt besteht der Multilayer ansonsten aus Glas 7. Auf der Unterseite 22 der Leiterplatte 2 können auch sonstige Leiterbahnen und Multilayer aufgebracht sein. Dann ist darauf zu achten, daß es zu keinen unbeabsichtigten Kurzschlüssen zwischen den Leitungen und dem Schirmgehäusedeckel 15 kommt.

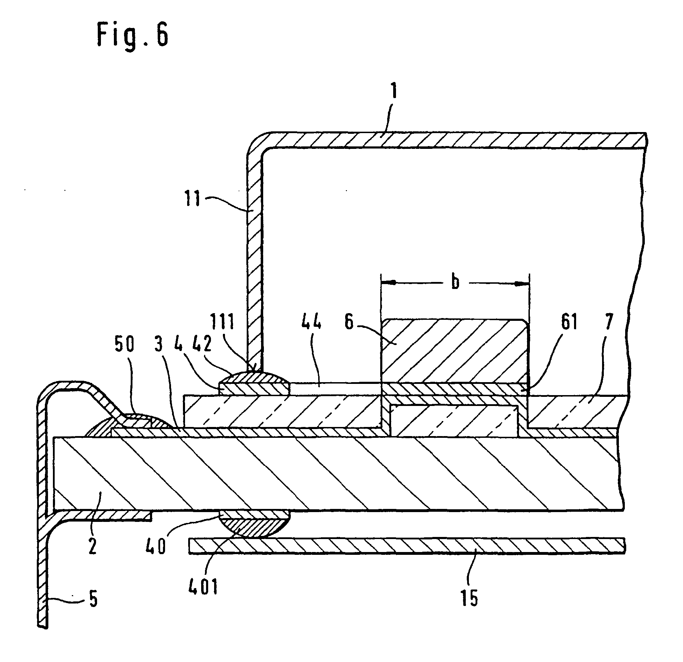

In Figur 6 wird die Unterseite 111 der Längsseite 11 auf den Löthöcker 42 gepreßt und so elektrisch mit der Masseringleitung 4 verbunden. Die Anschlußleitung 3 ist auf der Leiterplatte 2 unterhalb der Masseringleitung 4 hindurch in das Innere des Schirmgehäuses geführt. Sie wechselt aber unterhalb des Anschluß-Pins 61 des Kondensators 6 die Multilayer-Ebene. Hierdurch wird die mit dem Kondensator 6 kurzzuschließende Hochfrequenz über den Anschluß-Pin 61 des Kondensators 6, den Kondensator 6, den Anschluß-Pin 62 des Kondensators 6 und die Massezuführung 44 auf die Masseringleitung 4 und das Schirmgehäuse 1 gezwungen. Bei einer geraden Leiterbahnführung der Anschlußleitung 3 ohne Abwinklungen unterhalb des Anschluß-Pins 61 kann es möglich sein, daß die Hochfrequenz nicht die Anschlußleitung 3 verläßt.

Um mögliche Größenordnungen zu verdeutlichen, sei erwähnt, daß bei Verwendung von Keramik-Kondensatoren der Baugröße 0603 für die Kondensatoren 6 das Maß b (die Breite des Kondensators) etwa 0,75 mm beträgt. Somit wird erkennbar, daß die wirksame Länge der Anschlußleitung 3, die innerhalb des Schirmgehäuses nicht durch einen Kondensator 6 störfrequenzmäßig kurzgeschlossen ist, sehr kurz ist, so daß beim vorbeschriebenen Beispiel Störfrequenzen auf der Anschlußleitung 3 bis 1 GHz unterdrückt werden können, und zwar sowohl solche, die von dem Mikroprozessor 203 innerhalb des Schirmgehäuses erzeugt werden und nicht nach außen gelangen sollen als auch solche, die außerhalb des Gehäuses in die Anschlußleitungen 3 gelangen und nicht in das Innere des Schirmgehäuses durchgelassen werden sollen. Die wirksame Länge der Anschlußleitung 3 zwischen dem Schirmgehäuse und dem Kondensator 6 ist so kurz, daß sie nicht als Sendeantenne für auf der Anschlußleitung von außen nach innen strebenden Störfrequenzen dienen kann. Sie kann ebenfalls nicht als Empfangsantenne für innerhalb des Schirmgehäuses vorhandene Störfrequenzen dienen. Bei einer zu langen ungeschützten Anschlußleitung 3 könnten ansonsten die Störfrequenzen über die Anschlußleitung 3 das Schirmgehäuse verlassen.

Das vorbeschriebene Schirmgehäuse und der dadurch geschützte elektronische Schaltkreis sind kompakt aufgebaut, was als weiteren Vorteil einen geringen Bedarf an Keramik, Leiterbahn und lsoliermaterial bedingt, während die Grundplatte 9 fast nur noch Verbindungsfunktionen zu erfüllen hat und deshalb aus einfachem, preisgünstigen Leiterplattenmaterial hergestellt sein kann.

## Patentansprüche

1. Elektronischer Schaltkreis, bestehend aus elektrischen und elektronischen Bauelementen (201, 202, 203, 204) und deren Verbindungsleitungen auf einer Leiterplatte (2), wobei ein Schirmgehäuse den elektronischen Schaltkreis zur Verhinderung von Störungen, die auf den elektronischen Schaltkreis einwirken und die durch den elektronischen Schaltkreis hervorgerufen werden, hochfrequenzbedämpfend umschließt, wobei der Schaltkreis aus dem Schirmgehäuse nach außen führende Anschlussleitungen aufweist, insbesondere zur Verwendung in einem Kombi-Anzeigeinstrument eines Kraftfahrzeuges, **dadurch gekennzeichnet, dass** Anschlussleitungen (3) des elektronischen Schaltkreises auf der Leiterplatte (2) aus dem Schirmgehäuse (1, 15) geführt sind, dass Anschlussmittel (5) zum Anschluss des Schaltkreises an eine Grundplatte (9) außerhalb des Schirmgehäuses (1, 15) mit den Anschlussleitungen (3) verbunden sind, und dass Abschirmmittel vorhanden sind, die den Eintritt von hochfrequenten Störungen aus dem Schirmgehäuse (1, 15) reduzieren oder unterdrücken.

2. Elektronischer Schaltkreis nach Anspruch 1, **dadurch gekennzeichnet, daß** die Abschirmmittel derart ausgestaltet sind, daß auf der Leiterplatte (2) Kontaktmittel (41, 42, 401) vorhanden sind, die elektrisch leitend mit dem Schirmgehäuse (1, 15) verbunden sind, daß Kondensatoren (6) die Anschlußleitung (3) des elektronischen Schaltkreises und die Kontaktmittel (41, 42, 401) innerhalb des Schirmgehäuses wechselstrommäßig verbinden.

3. Elektronischer Schaltkreis nach Anspruch 2, **dadurch gekennzeichnet, daß** die Verbindung zwischen den Kontaktmitteln (41, 42, 401) und dem Schirmgehäuse (1, 15) durch Druckkontakte ausgeführt sind.

4. Elektronischer Schaltkreis nach Anspruch 3, **dadurch gekennzeichnet, daß** die Kontaktmittel als Löthöcker (41, 42, 401) ausgebildet sind.

5. Elektronischer Schaltkreis nach Anspruch 2, 3 oder 4, **dadurch gekennzeichnet, daß** die Kontaktmittel (41, 42, 401) durch eine oder mehrere Masseringleitungen (4, 40) verbunden sind.

6. Elektronischer Schaltkreis nach Anspruch 5, **dadurch gekennzeichnet, daß** die Masseringleitungen (4, 40) mittels Durchkontaktierungen (46) miteinander elektrisch leitend verbunden sind.

7. Elektronischer Schaltkreis nach Anspruch 2, 3, 4, 5 oder 6, **dadurch gekennzeichnet, daß** die Längsseiten (11) des Schirmgehäuses (1, 15) auf die Kontaktmittel (41, 42) gepreßt werden und so den elektrischen Kontakt zwischen Schirmgehäuse und den Kontaktmitteln herstellen.

8. Elektronischer Schaltkreis nach einem der vorstehenden Ansprüche, **dadurch gekennzeichnet, daß** das Schirmgehäuse eine Schirmgehäusedose (1) und einen Schirmgehäusedeckel (15) aufweist, wobei die Schirmgehäusedose (1) und der Schirmgehäusedeckel (15) jeweils auf Löthöcker (41, 42, 401) auf der Oberseite (21) bzw. der Unterseite (22) der Leiterplatte (2) gedrückt werden.

9. Elektronischer Schaltkreis nach Anspruch 8, **dadurch gekennzeichnet, daß** die Schirmgehäusedose (1) mit der Unterseite (111) ihrer Längsseite (11) den Schirmgehäusedeckel (15) kontaktiert.

10. Elektronischer Schaltkreis nach einem der Ansprüche 2 bis 9, **dadurch gekennzeichnet, daß** die Kontaktmittel aus Zinn bestehen und das Schirmgehäuse (1, 15) aus verzinntem ferromagnetischem Material besteht.

11. Elektronischer Schaltkreis nach einem der vorstehenden Ansprüche 6, 7, 8, 9 oder 10, **dadurch gekennzeichnet, daß** die Leiterplatte (2) Schlitze (26) aufweist, durch die die Biegelaschen (12) der Schirmgehäusedose geführt sind.

12. Elektronischer Schaltkreis nach einem der vorstehenden Ansprüche, **dadurch gekennzeichnet, daß** die Leiterplatte (2) aus Aluminiumoxid-Keramik besteht.

13. Elektronischer Schaltkreis nach Anspruch 12, **dadurch gekennzeichnet, daß** der Schaltkreis in Multilayer-Technik ausgeführt ist.

14. Elektronischer Schaltkreis nach einem der Ansprüche 2 bis 13, **dadurch gekennzeichnet, daß** die Kondensatoren (6) jeweils auf die Störfrequenz mit der höchsten Amplitude der jeweiligen Anschlußleitung (3) abgestimmt sind.

15. Elektronischer Schaltkreis nach einem der vorstehenden Ansprüche, **dadurch gekennzeichnet, daß** die Anschlußmittel als Kontaktfedern (5) realisiert sind.

## Claims

1. Electronic circuit, comprising electrical and electronic components (201, 202, 203, 204) and their connecting lines on a printed circuit board (2), in which case a screened housing encloses the electronic circuit, attenuating radiofrequencies, in order to prevent interference which acts on the electronic circuit and interference which is caused by the electronic circuit, in which case the circuit has connecting lines which lead out of the screened housing to the exterior, in particular for use in a combination display instrument in a motor vehicle, **characterized in that** connecting lines (3) from the electronic circuit on the printed circuit board (2) are passed out of the screened housing (1, 15), **in that** connecting means (5) for connecting the circuit onto a base plate outside the screened housing (1, 15) are connected to the connecting lines (3), and **in that** screening means are provided which reduce or suppress the ingress of radio-frequency interference into the screened housing (1, 15).

2. Electronic circuit according to claim 1, wherein the screening means are designed in such a manner that there are contact means (41, 42, 401) on the printed circuit board (2), which are electrically conductively connected to the screened housing (1, 15), and wherein capacitors (6) provide AC coupling between the connecting line (3) from the electronic circuit and the contact means (41, 42, 401) inside the screened housing.

3. Electronic circuit according to claim 2, wherein the connection between the contact means (41, 42, 401) and the screened housing (1, 15) is in the form of pressure contacts.

4. Electronic circuit according to claim 3, wherein the contact means are designed as solder studs (41, 42, 401).

5. Electronic circuit according to claim 2, 3, or 4, wherein the contact means (41, 42, 401) are connected by means of one or more ground ring lines (4, 40).

6. Electronic circuit according to claim 5, wherein the ground ring lines (4, 40) are electrically conductively connected to one another by means of plated-through holes (46).

7. Electronic circuit according to claim 2, 3, 4, 5 or 6, wherein the longitudinal sides (11) of the screened housing (1, 15) are pressed against the contact means (41, 42) and thus produce the electrical contact between the screened housing and the contact means.

8. Electronic circuit according to one of the preceding claims, wherein the screened housing has a screened housing case (1) and a screened housing cover (15), in which case the screened housing case (1) and the screened housing cover (15) are respectively pressed against solder studs (41, 42, 401) on the top surface (21) and the bottom surface (22) of the printed circuit board (2).

9. Electronic circuit according to claim 8, wherein the bottom edge (111) of the longitudinal side (11) of the screened housing case (1) makes contact with the screened housing cover (15).

10. Electronic circuit according to one of claims 2 to 9, wherein the contact means are composed of tin, and the screened housing (1, 15) is composed of galvanized ferromagnetic material.

11. Electronic circuit according to one of the preceding claims 6, 7, 8, 9 or 10, wherein the printed circuit board (2) has slots (26) through which the bending lugs (12) on the screened housing case are passed.

12. Electronic circuit according to one of the preceding claims, wherein the printed circuit board (2) is composed of aluminum-oxide ceramic.

13. Electronic circuit according to claim 12, wherein the circuit is designed using multilayer technology.

14. Electronic circuit according to one of claims 2 to 13, wherein the capacitors (6) are respectively tuned to the interference frequency having the greatest amplitude on the respective connecting line (3).

15. Electronic circuit according to one of the preceding claims, wherein the connecting means are in the form of contact springs (5).

## Revendications

1. Circuit électronique composé de composants électriques et électroniques (201, 202, 203, 204) et des conducteurs qui les relient sur une carte à circuits imprimés (2), où un boîtier de blindage entoure le circuit électronique et affaiblit les hautes fréquences pour éviter des perturbations qui agissent sur le circuit électronique et qui sont produites par le circuit électronique, où le circuit comporte des conducteurs de raccordement sortant du boîtier de blindage vers l'extérieur, ledit circuit électronique étant notamment destiné à être utilisé dans un instrument combiné d'affichage d'un véhicule automobile, **caractérisé par le fait que** des conducteurs de raccordement (3) du circuit électronique sur la carte à circuits imprimés (2) sortent du boîtier de blindage (1, 15), que des moyens de raccordement (5) destinés à raccorder le circuit à une plaque de base (9) sont raccordés aux conducteurs de raccordement (3) à l'extérieur du boîtier de blindage (1, 15) et qu'il existe des moyens de blindage qui réduisent ou qui éliminent l'entrée de parasites à haute fréquence à l'extérieur du boîtier de blindage (1, 15).

2. Circuit électronique selon la revendication 1, **caractérisé par le fait que** les moyens de blindage sont conçus de telle manière que, sur la carte à circuits imprimés (2), il y a des moyens de contact (41, 42, 401) qui sont reliés électriquement au boîtier de blindage (1, 15), que des condensateurs (6) relient, à l'intérieur du boîtier de blindage, en courant alternatif, le conducteur de raccordement (3) du circuit électronique et les moyens de contact (41, 42, 401).

3. Circuit électronique selon la revendication 2, **caractérisé par le fait que** la liaison entre les moyens de contact (41, 42, 401) et le boîtier de blindage (1, 15) est réalisée par des contacts à pression.

4. Circuit électronique selon la revendication 3, **caractérisé par le fait que** les moyens de contact sont réalisés en tant que plots de soudure (41, 42, 401).

5. Circuit électronique selon la revendication 2, 3 ou 4, **caractérisé par le fait que** les moyens de contact (41, 42, 401) sont reliés par une ou plusieurs lignes de masse en boucle (4, 40).

6. Circuit électronique selon la revendication 5, **caractérisé par le fait que** les lignes de masse en boucle (4, 40) sont reliées électriquement l'une à l'autre au moyen de contacts métallisés traversants (46).

7. Circuit électronique selon la revendication 2, 3, 4, 5 ou 6, **caractérisé par le fait que** les côtés longs (11) du boîtier de blindage (1, 15) sont appuyés sur les moyens de contact (41, 42) et établissent ainsi le contact électrique entre le boîtier de blindage et les moyens de contact.

8. Circuit électronique selon l'une des revendications précédentes, **caractérisé par le fait que** le boîtier de blindage comporte un corps (1) de boîtier et un couvercle (15) de boîtier, où le corps (1) du boîtier de blindage et le couvercle (15) du boîtier de blindage sont chacun pressés sur des plots de soudure (41, 42, 401) se trouvant sur la face supérieure (21) et, respectivement, sur la face inférieure (22) de la carte à circuits imprimés (2).

9. Circuit électronique selon la revendication 8, **caractérisé par le fait que** le corps (1) du boîtier de blindage établit, par la face inférieure (111) de son côté long (11), le contact électrique avec le couvercle (15) du boîtier de blindage.

10. Circuit électronique selon l'une des revendications 2 à 9, **caractérisé par le fait que** les moyens de contact sont en étain et que le boîtier de blindage (1, 15) est en matière ferromagnétique étamée.

11. Circuit électronique selon l'une des revendications précédentes 6, 7, 8, 9 ou 10, **caractérisé par le fait que** la carte à circuits imprimés (2) a des fentes (26) à travers lesquelles passent les pattes à replier (12) du corps du boîtier de blindage.

12. Circuit électronique selon l'une des revendications précédentes, **caractérisé par le fait que** la carte à circuits imprimés (2) est en céramique à oxyde d'aluminium.

13. Circuit électronique selon la revendication 12, **caractérisé par le fait que** le circuit est réalisé en technologie à multicouche.

14. Circuit électronique selon l'une des revendications 2 à 13, **caractérisé par le fait que** les condensateurs (6) sont, dans chaque cas, accordés sur la fréquence parasite du conducteur de raccordement (3) respectif ayant l'amplitude la plus élevée.

15. Circuit électronique selon l'une des revendications précédentes, **caractérisé par le fait que** les moyens de raccordement sont réalisés sous la forme de ressorts de contact (5).
